# EUROPEAN PATENT APPLICATION

(11) **EP 2 987 891 A2**
(43) Date of publication of application: **24.02.2016**
(21) Application number: 15179663.8
(22) Date of filing: 04.08.2015
(51) Int. Cl.: C23C 16/48, C23C 16/52, C23C 16/455

(54) **CHEMICAL VAPOR DEPOSITION SYSTEM, ARRANGEMENT OF CHEMICAL VAPOR DEPOSITION SYSTEMS, AND CHEMICAL VAPOR DEPOSITION METHOD**

(30) Priority: 19.08.2014 US 201462038918 P
(71) Applicant: SilcoTek Corporation, Bellefonte, PA 16823 (US)
(72) Inventor: DESKEVICH, Nicholas Peter, Hollidaysburg, PA 16648 (US); GROVE, William David, Boalsburg, PA 16827 (US)
(74) Representative: Loock, Jan Pieter

(57) **Abstract**

A chemical vapor deposition system, method and arrangement of systems are disclosed. The system includes a coating chamber, a fluid introduction system, and an arrangement of radiant heating elements. The coating chamber has an enclosing border extending around a coating region and an access portion positioned in an axial orientation relative to the enclosing border, the coating chamber being in a fixed and horizontal position. The fluid introduction system includes a vacuum pump and a fluid introduction arrangement arranged and disposed to introduce a fluid to the coating chamber for chemical vapor deposition coating of an article in the coating chamber. The arrangement of radiant heating elements is positioned outside of the coating chamber and is thermally connected with the enclosing border of the coating chamber to heat zones within the coating chamber. The method uses the system. The arrangement includes more than one of the chemical vapor deposition systems.

## Description

### FIELD OF THE INVENTION

The present invention is directed to systems having process chambers and methods of operating process chambers. More specifically, the present invention is directed to chemical vapor deposition systems, arrangements or systems, and methods.

### BACKGROUND OF THE INVENTION

Traditionally chemical vapor deposition has been a desirable process for coating substrates due to the flexibility of operational parameters. Chemical vapor deposition can produce coated articles with relative consistency at a lower cost than systems that operate under higher precision parameters, for example, temperature ranges and pressure ranges. However, treatment and coating processes requiring narrower temperature ranges and pressure ranges have been long-felt as unsuitable for chemical vapor deposition systems due to the inability for chemical vapor deposition systems to maintain precise temperature and/or pressure ranges.

Many known chemical vapor systems operate with a temperature differential of greater than 50°C. A number of known chemical vapor deposition systems suffer from loss of heat and/or other undesirable operational effects due to access portions being positioned in a vertical position relative to the coating chamber. Yet other known chemical vapor deposition systems rely upon convective heat while rotating a coating chamber, which can produce limitations on the ability to coat certain materials and creates mechanical features that can breakdown or introduce additional inconsistencies during operation.

Known chemical vapor deposition systems also fail to operate in conjunction with other parallel or sequential systems. Such individual operation has been performed due to the desire to maintain one set of parameters at a time. However, such individual operation requires duplication of certain portions of chemical vapor deposition systems and does not permit operational benefits found through operating a plurality of chemical vapor deposition systems together. For example, parallel operation, in contrast to sequential operation, of a plurality of systems can produce a larger draw on the energy grid. Such a draw can be costly due to the power usage rates and/or can unnecessarily add to overall stress on the energy grid.

Initial attempts to produce a system capable of overcoming all of the above drawbacks were unsuccessful. For example, certain configurations including diaphragm valves resulted in dust getting into valves, which adversely affects operation. In addition, operation with a vacuum gauge, which operates based upon heat loss due to convection at higher pressure, resulted in undesirable process results.

A chemical vapor deposition system, arrangement of chemical vapor deposition systems, and chemical vapor deposition method that show one or more improvements in comparison to the prior art would be desirable in the art.

### BRIEF DESCRIPTION OF THE INVENTION

In an embodiment, a chemical vapor deposition system includes a coating chamber, a fluid introduction system, and an arrangement of radiant heating elements. The coating chamber has an enclosing border extending around a coating region and an access portion positioned in an axial orientation relative to the enclosing border, the coating chamber being in a fixed and horizontal position. The fluid introduction system includes a vacuum pump and a fluid introduction arrangement arranged and disposed to introduce a fluid to the coating chamber for chemical vapor deposition coating of an article in the coating chamber. The arrangement of radiant heating elements is positioned outside of the coating chamber and is thermally connected with the enclosing border of the coating chamber to heat zones within the coating chamber. The radiant heating elements are arranged and disposed to maintain a temperature differential of less than 50°C within the coating chamber during the chemical vapor deposition.

In another embodiment, an arrangement of chemical vapor deposition systems includes a first chemical vapor deposition system including a first coating chamber, a second chemical vapor deposition system including a second coating chamber, and a fluid introduction system including a vacuum pump and a fluid introduction arrangement arranged and disposed to introduce a fluid to one or both of the first coating chamber and the second coating chamber for chemical vapor deposition coating. At least a portion of the fluid introduction system is arranged for operation with the first chemical vapor deposition system and the second chemical vapor deposition system.

In another embodiment, a chemical vapor deposition method includes providing a first chemical vapor deposition system including a first coating chamber and providing a fluid introduction system including a vacuum pump and a fluid introduction arrangement arranged and disposed to introduce a fluid to the first coating chamber. The method further includes one or both of (1) maintaining a temperature differential of less than 50°C in the first coating chamber during chemical vapor deposition by selectively operating radiant heating elements arranged and disposed to maintain the temperature and (2) operating a second chemical vapor deposition system comprising a second coating chamber with at least a portion of the fluid introduction system.

Other features and advantages of the present invention will be apparent from the following more detailed description, taken in conjunction with the accompanying drawings which illustrate, by way of example, the principles of the invention.

### BRIEF DESCRIPTION OF THE DRAWINGS

FIG. 1 is a perspective view of a chemical vapor deposition system showing a coating chamber and an access portion, according to an embodiment of the disclosure.
FIG. 2 is a perspective view of a chemical vapor deposition system showing fluid introduction system including a vacuum pump and a fluid introduction arrangement, according to an embodiment of the disclosure.
FIG. 3 is a schematic view of zones in a coating chamber of a chemical vapor deposition system having a geometry of a dodecagonal prism, according to an embodiment of the disclosure.
FIG. 4 is a schematic view of an arrangement of chemical vapor deposition systems with at least a portion of a fluid introduction system being arranged for operation with two or more chemical vapor deposition systems.

Wherever possible, the same reference numbers will be used throughout the drawings to represent the same parts.

### DETAILED DESCRIPTION OF THE INVENTION

Provided are a chemical vapor deposition system, an arrangement of chemical vapor deposition systems, and a chemical vapor deposition method. Embodiments of the present disclosure, for example, in comparison to concepts failing to include one or more of the features disclosed herein, permit uniform or substantially uniform heating with less than an identifiable temperature differential (for example, while a coating region is devoid of heaters, reflectors, water-cooling elements, and/or heat-spreading elements), reduce or eliminate hot or cold spots within a chamber, permit coating of a wider range of geometries (for example, narrow channels/tubes, three-dimensionally complex geometries, and/or hidden or non-line-of-site geometries, such as, in needles, tubes, probes, fixtures, and the like), permit coating of a bulk of articles, permit energy management based upon operating a plurality of systems, permit resource management (for example, by utilizing one or more components for two or more systems), or permit a combination thereof.

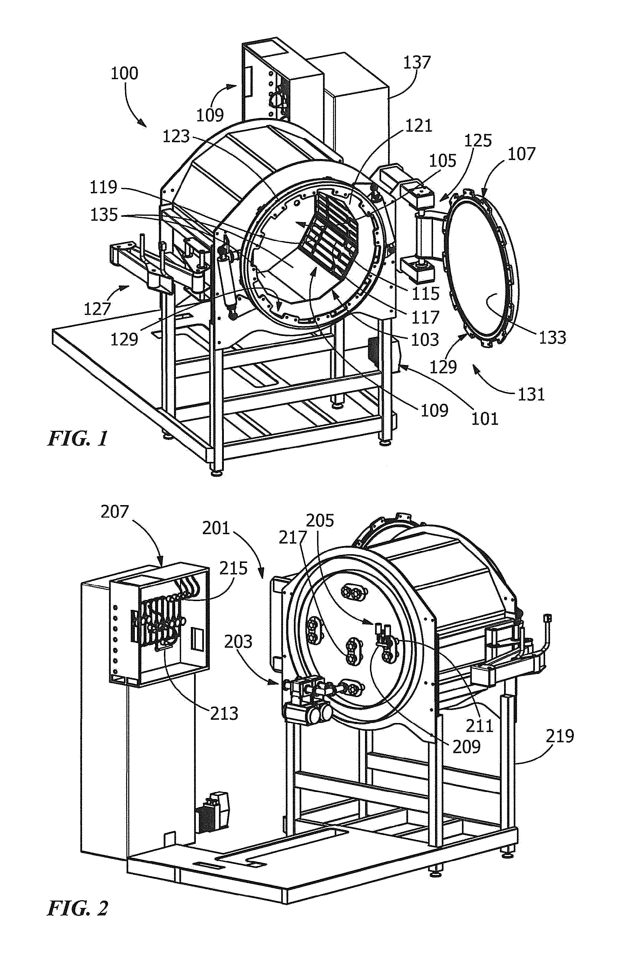

FIG. 1 shows a chemical vapor deposition system 100. The chemical vapor deposition system 100 is capable of performing processes at a variety of operational parameters. The parameters can be maintained by measuring, monitoring, adjusting, and/or modeling data or other information about the system, for example, on-site and/or remotely (such as, through the internet). Suitable parameters include, but are not limited to, energy usage/draw, pressure, temperature, flow-rate and/or flow-duration, and compositions of one or more fluids. For example, in one embodiment, energy management is performed by operating a plurality of chemical vapor deposition systems 100 at a draw below a suitable power draw, for example, 30 kw, 35 kw, and/or 40 kw.

Pressure values are monitored by any suitable device. In one embodiment, the pressure is monitored by capacitance manometers. Suitable pressures include, but are not limited to, between about 0.01 psia and about 200 psia, between about 1.0 psia and about 100 psia, between about 5 psia and about 40 psia, between about 20 psia and about 25 psia, about 1.0 psia, about 5 psia, about 20 psia, about 23 psia, about 25 psia, about 40 psia, about 100 psia, 200 psia, or any suitable combination, sub-combination, range, or sub-range therein.

Temperature values are monitored by any suitable device. In one embodiment, the temperature is monitored by heat measuring devices 135, for example, thermocouples, as shown in FIG. 1. Suitable temperatures include, but are not limited to, between about 100°C and about 700°C, between about 100°C and about 450°C, between about 100°C and about 300°C, between about 200°C and about 500°C, between about 300°C and about 600°C, between about 450°C and about 700°C, about 700°C, about 450°C, about 100°C, between about 200°C and 600°C, between about 300°C and 600°C, between about 400°C and about 500°C, about 300°C, about 400°C, about 500°C, about 600°C, or any suitable combination, sub-combination, range, or sub-range thereof.

In one embodiment, flow-rates are monitored, calculated, or determined. Suitable flow-rates include, but are not limited to, being based upon a flow-duration of between about 30 minutes and 6 hours, between about 30 minutes and about 4 hours, between about 1 hour and about 4 hours, up to about 10 hours, up to about 4 hours, up to about 2 hours, up to about 30 minutes, 10 minutes to about 24 hours, about 30 minutes to about 24 hours, about 10 minutes, about 30 minutes, about 15 hours, about 24 hours, or any combination, sub-combination, range or sub-range thereof.

Suitable compositions flowing to the system 100 include, but are not limited to, dimethylsilane (for example, in gaseous form), trimethylsilane, dialkylsilyl dihydride, alkylsilyl trihydride, non-pyrophoric species (for example, dialkylsilyl dihydride and/or alkylsilyl trihydride), inert gas (for example, nitrogen, helium, and/or argon, as a partial pressure dilutant) thermally decomposed material (for example, carbosilane, such as, amorphous carbosilane), species capable of a recombination of carbosilyl (disilyl or trisilyl fragments), water (alone, with zero air, or with an inert gas), oxygen, air (alone, not alone, and/or as zero air), nitrous oxide, ozone, peroxide, or a combination thereof. As used herein, the term "zero air" refers to atmospheric air having less than about 0.1 ppm total hydrocarbons.

The system 100 includes a coating chamber 101 and a fluid introduction system 201, as is shown and described with reference to FIG. 2. The coating chamber 101 is in a fixed and horizontal position. As used herein, directional terms, such as "horizontal," refer to the direction relative or substantially relative to the direction of gravity. For example, the term "horizontal" is to be considered perpendicular or substantially perpendicular to the direction of gravity.

Referring again to FIG. 1, in one embodiment, the coating chamber 101 includes an access portion 107, for example, a sealable assembly 131 having a door 133, a gasket 123, a pivot feature 125, a force-providing locking feature 127, interlocking features 129, any other suitable features for providing sealing the access portion, or a combination thereof. The door 133 is heated by including an internal heating element or is a single material, such as steel. In one embodiment, the access portion 107 is positioned horizontally and/or in an axial orientation relative to an enclosing border 103. A second door or a back wall in the enclosing border 103 is also capable of being included.

The coating chamber 101 is symmetric, substantially symmetric, or asymmetric. In one embodiment, the coating chamber 101 is symmetric or substantially symmetric along at least 1 plane, along at least 2 planes, along at least 3 planes, along at least 4 planes, along at least 6 planes, along an infinite number of planes, along one or more radial planes, along one or more axial planes, along a horizontal plane, along a vertical plane, or any suitable combination or sub-combination thereof.

The coating chamber 101 includes any suitable dimensions permitting coating of one article or a plurality of articles. Suitable dimensions include, but are not limited to, having a minimum width of the enclosing border 103 being greater than 10 cm, greater than 20 cm, greater than 30 cm, greater than 100 cm, greater than 300 cm, greater than 1,000 cm, between 10 cm and 100 cm, between 100 cm and 300 cm, between 100 cm and 1,000 cm, between 300 cm and 1,000 cm, any other minimum width capable of uniform or substantially uniform heating, or any suitable combination, sub-combination, range, or sub-range therein. Suitable volumes include, but are not limited to, greater than 3,000 cm³, greater than 5,000 cm³, greater than 10,000 cm³, greater than 20,000 cm³, between 3,000 cm³ and 5,000 cm³, between 5,000 cm³ and 10,000 cm³, between 5,000 cm³ and 20,000 cm³, between 10,000 cm³ and 20,000 cm³, any other volumes capable of uniform or substantially uniform heating, or any suitable combination, sub-combination, range, or sub-range therein.

In one embodiment, the coating chamber 101 includes the enclosing border 103 extending around a coating region 105. The enclosing border 103 is or includes metal material

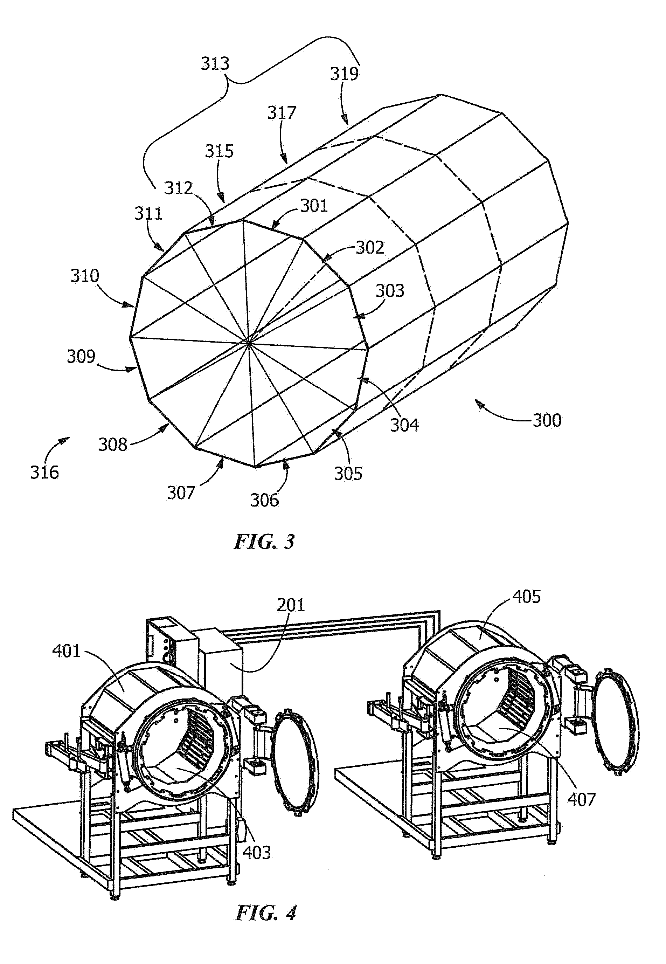

(for example, stainless steel or steel), metallic material, ceramics, or a combination thereof and defines the coating region 105 and provides a region for an article to be coated within the coating chamber 101. In one embodiment, the enclosing border 103 includes a plurality of surfaces 113, such as equally-sized or unequally-sized substantially planar surfaces, arched surfaces, irregular surfaces, members, or a combination thereof. The surfaces 113 provide a seal for the coating region 105 by being secured to one another (for example, by welding, mechanically joining, and/or adhesive coupling) or are secured through one or more intermediate bodies (not shown), such as, gaskets. Any suitable number of the surfaces 113 is included in the enclosing border 103, for example, at least two of the surfaces 113, at least three of the surfaces 113, at least four of the surfaces 113, at least five of the surfaces 113, at least six of the surfaces 113, at least seven of the surfaces 113, at least eight of the surfaces 113, at least nine of the surfaces 113, at least ten of the surfaces 113, at least eleven of the surfaces 113, at least twelve of the surfaces 113, or any suitable combination, sub-combination, range, or sub-range therein. In one embodiment, one or more of the surfaces 113 provides a resting or stable zone for the article, a plurality of the articles, a fixture for holding the article(s), or a plurality of the fixtures. In one embodiment, the surfaces 113 form a dodecagonal prism, similar to that which is shown in FIG. 3.

The enclosing border 103 is thermally connected with radiant heating elements 109 positioned outside of the coating chamber 101 and the enclosing border 103 of the coating chamber 101. In one embodiment, a heat-directing enclosure 121 shields outside from receiving the heat and/or directs heat inward toward the coating chamber 101, for example, to direct heat from the radiant heating elements 109 through the enclosing border 103 into the coating chamber 101. The radiant heating elements 109 are positioned in physical contact with the enclosing border 103 distal from the surfaces 113 or within a proximity that permits heat to be transferred to the surfaces 113 and then within the coating chamber 101. The heat transferred into the coating chamber 101 from the radiant heating elements 109 permits heat zones 300, such as those in FIG. 3, to be maintained at less than a temperature differential.

For example, as shown in FIG. 3, the heat zones 300 include radial regions 313 (extending along radial cross-sections of the coating region 105) and axial heat zones 316 (axially extending through the coating region 105). As will be appreciated by those skilled in the art, each of the radiant heating elements 109 impacts the heat zones 300 within the coating region 105 differently. The radiant heating elements 109 each include one or more heaters (such as, access-portion-proximal-positioned heaters 115, mid-positioned heaters 117, and access-portion-distal-positioned heaters 119), which are resistive heaters or other heaters capable of providing radiant heat (and/or capable of producing heat without being convective heat). In one embodiment, the heaters are not printed circuit heaters and/or do not generate convective heat.

The heaters are planar, are substantially planar, are coiled, are separated (for example, axially or radially), have any other suitable configuration, or a combination thereof, to maintain a heat profile. The temperature within the coating region 105 is maintained by any suitable number of the radiant heating elements 109 and/or heaters capable of maintaining less than the temperature differential (for example, at least three individual heaters, at least four individual heaters, at least six individual heaters, at least two of the radiant heating elements 109, at least three of the radiant heating elements 109, at least four of the radiant heating elements 109, at least six of the radiant heating elements 109, at least nine of the radiant heating elements 109, at least twelve of the radiant heating elements 109, or any suitable combination or sub-combination thereof). For example, in an embodiment with the coating region 105 being a dodecagonal prism, twelve of the radiant heating elements 109 are positioned equally around the coating region 105, with each of the radiant heating elements 109 including three heaters, the access-portion-proximal-positioned heater 115, the mid-positioned heater 117, and the access-portion-distal-positioned heater 119.

Adjustments to the temperature of the radiant heating elements 109 and/or one or more of the access-portion-proximal-positioned heaters 115, the mid-positioned heaters 117, the access-portion-distal-positioned heaters 119, within the radiant heating elements 109 permits the temperature to be maintained at less than the temperature differential within the radial regions 315, such as, a first radial region 315, a second radial region 317, and a third radial region 319, with the first radial region 315 being positioned proximal to access portion 107, the third radial region 319 being positioned distal from the access portion, and the second radial region 317 being positioned between the first radial region 315 and the third radial region 319.

Similarly, adjustments to the temperature of the radiant heating elements 109 and/or one or more of the access-portion-proximal-positioned heaters 115, the mid-positioned heaters 117, the access-portion-distal-positioned heaters 119, within the radiant heating elements 109 permit the temperature to be maintained at less than the temperature differential within the axial heat zones 316, such as, a first axial zone 301 (for example, generally corresponding with 1 o'clock on a clock), a second axial zone 302 (for example, generally corresponding with 2 o'clock on a clock), a third axial zone 303 (for example, generally corresponding with 3 o'clock on a clock), a fourth axial zone 304 (for example, generally corresponding with 4 o'clock on a clock), a fifth axial zone 305 (for example, generally corresponding with 5 o'clock on a clock), a sixth axial zone 306 (for example, generally corresponding with 6 o'clock on a clock), a seventh axial zone 307 (for example, generally corresponding with 7 o'clock on a clock), an eighth axial zone 308 (for example, generally corresponding with 8 o'clock on a clock), a ninth axial zone 309 (for example, generally corresponding with 9 o'clock on a clock), a tenth axial zone 310 (for example, generally corresponding with 10 o'clock on a clock), an eleventh axial zone 311 (for example, generally corresponding with 11 o'clock on a clock), a twelfth axial zone 312 (for example, generally corresponding with 12 o'clock on a clock).

In one embodiment, the temperature differential during the chemical vapor deposition process is less than 50°C, less than 40°C, less than 30°C, less than 20°C, less than 10°C, between 10°C and 50°C, between 10°C and 30°C, between 10°C and 20°C, between 20°C and 50°C, between 20°C and 30°C, between 30°C and 50°C, or any suitable combination, sub-combination, range, or sub-range therein. The temperature differential is monitored and/or adjusted in response to heat measuring devices 135, such as thermocouples, positioned within the chemical vapor deposition system 100, for example, outside of the coating chamber 101 but in thermal contact with the surfaces 113, as is shown in FIG. 1, proximal to the radiant heating elements 109, within the coating chamber 101, or in any other region capable of providing complete or substantially complete data regarding the temperatures within the coating chamber 101. In one embodiment, the thermocouples operate in conjunction with a controller 137, for example, a programmable logic controller and/or a temperature controller, to achieve aspects of the chemical vapor deposition processes disclosed herein.

Referring to FIG. 2, the fluid introduction system 201 includes any suitable features for applying a chemical vapor deposition fluid (not shown) to the coating region 105 of the coating chamber 101 of the chemical vapor deposition system 100. The fluid introduction system 201 includes a vacuum pump 203 and a fluid introduction arrangement 205 arranged and disposed to introduce the chemical vapor deposition fluid for chemical vapor deposition coating of the article in the coating chamber 101. The chemical vapor deposition fluid includes one or more species distributed from a manifold 207 to the fluid introduction system 201. Other suitable components of the fluid introduction system 201 include, but are not limited to, one or more inlet flow valves 209, inlet flow paths 211, distributing flow valves 213 (for example, in the manifold 207), distributing flow paths 215 (for example, in the manifold 207), one or more waste streams 217 (for example, extending from the coating chamber 101), or a stabilizing structure 219. In one embodiment, the distributing flow valves 213 are vacuum-rated for 10⁻⁶ Torr, include a synthetic fluoropolymer seal, include ball valves, operate in the presence of particulate, or a combination thereof. In one embodiment, the distributing flow paths 215 include transducers, such as, hermetically-sealed and corrosion-resistant transducers.

In one embodiment, at least a portion of the fluid introduction system 201 is arranged for operation with more than one of the chemical vapor deposition systems 100, for example, sequential or simultaneous. For example, referring to FIG. 4, in one embodiment, a plurality of the chemical vapor deposition systems 100 includes a first chemical vapor deposition system 401 having a first coating chamber 403 and a second chemical vapor deposition system 405 having a second coating chamber 407. In this embodiment, at least a portion of the fluid introduction system 201 is arranged for operation with the first chemical vapor deposition system 401 and the second chemical vapor deposition system 405. The first coating chamber 403 and the second coating chamber 407 are separate.

In a further embodiment, all portions of the fluid introduction system 201 except one or more inlet flow valves 209 and one or more inlet flow paths 211 are arranged for operation with more than one of the chemical vapor deposition systems 100. In one embodiment, the fluid introduction arrangement 205 introduces the chemical vapor deposition fluid to only the chemical vapor deposition system 100. In another embodiment, the fluid introduction system 201 introduces the chemical vapor deposition fluid to three, four, five, six, seven, eight or more of the chemical vapor deposition systems 101. Other suitable components of the fluid introduction system 201 that are capable of being similarly used for operation of one or more of the chemical vapor deposition systems 100 include, but are not limited to, one or more of the vacuum pumps 203, one or more of the manifolds 207, one or more of the distributing flow valves 213, one or more of the distributing flow paths 215, one or more of the waste streams 217 (for example, vents), one or more of the stabilizing structures 219, or any other suitable component capable of sequential or simultaneous operation with more than one of the chemical vapor deposition systems 100.

The portions of the chemical vapor deposition system 100 that are shared correspond with any suitable operational features. Suitable operational features include, but are not limited to, operational pressure ranges (for example, based upon separate ranges disclosed above), operational temperature ranges (for example, based upon separate ranges disclosed above), operational flow-rate ranges (for example, based upon separate ranges disclosed above), a family of fluids (for example, pyrophoric gases or non-pyrophoric gases), reactive profiles (for example, keeping a first gas separate from a second gas if they would react with each other), a group of chemical species (as identified based upon valances), effluent waste handling requirements (for example, based upon being a volatile organic compound or not, based upon being capable of being recycled or not, and/or based upon being capable of untreated disposal), or a combination thereof.

While the invention has been described with reference to one or more embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims. In addition, all numerical values identified in the detailed description shall be interpreted as though the precise and approximate values are both expressly identified.

## Claims

1. An arrangement of chemical vapor deposition systems, comprising:
a first chemical vapor deposition system comprising a first coating chamber;
a second chemical vapor deposition system comprising a second coating chamber; and
a fluid introduction system comprising a vacuum pump and a fluid introduction arrangement arranged and disposed to introduce a fluid to one or both of the first coating chamber and the second coating chamber for chemical vapor deposition coating;
wherein at least a portion of the fluid introduction system is arranged for operation with the first chemical vapor deposition system and the second chemical vapor deposition system.

2. The arrangement of claim 1, wherein the first chemical vapor deposition system and the second chemical vapor deposition system are thermal batch chemical vapor deposition systems.

3. The arrangement of claim 1, wherein the operation of the first chemical vapor deposition system and the second chemical vapor deposition system uses less energy than operation of two identical chemical vapor deposition systems operated separately.

4. The arrangement of claim 1, wherein the operation of the first chemical vapor deposition system and the second chemical vapor deposition system uses less of the fluid than operation of two identical chemical vapor deposition systems operated separately.

5. The arrangement of claim 1, wherein the operation of the first chemical vapor deposition system and the second chemical vapor deposition system uses less heat than operation of two identical chemical vapor deposition systems operated separately.

6. The arrangement of claim 1, wherein the first coating chamber and the second coating chamber are fixed and horizontal.

7. The arrangement of claim 1, wherein the second chemical vapor deposition system is arranged to receive effluent from the first chemical vapor deposition system.

8. The arrangement of claim 1, wherein the first chemical vapor deposition system and the second chemical vapor deposition system are arranged to combine effluents.

9. The arrangement of claim 1, wherein the first coating chamber has a volume of greater than 3,000 cm³.

10. The arrangement of claim 1, wherein the first coating chamber is symmetric or substantially symmetric along at least one plane.

11. The arrangement of claim 1, wherein the first coating chamber has an enclosing border with at least three substantially planar surfaces.

12. The arrangement of claim 11, wherein the enclosing border consists of twelve substantially planar surfaces.

13. The arrangement of claim 11, wherein the at least three substantially planar surfaces are in thermal contact with at least three radiant heating elements.

14. The arrangement of claim 13, wherein each of the radiant heating elements includes a first heater positioned to heat a first region of the enclosing border, a second heater positioned to heat a second region of the enclosing border, and a third heater positioned to heat a third region of the enclosing border, wherein the first region is positioned proximal to the access portion, the third region is positioned distal from the access portion, and the second region is positioned between the first region and the third region.

15. The arrangement of claim 13, wherein each of the radiant heating elements includes resistive heaters.

16. A chemical vapor deposition method, comprising:
providing a first chemical vapor deposition system comprising a first coating chamber;
providing a fluid introduction system arranged and disposed to introduce a fluid to the first coating chamber; and
operating a second chemical vapor deposition system comprising a second coating chamber with at least a portion of the fluid introduction system.

17. A chemical vapor deposition system, comprising:
a non-cuboid coating chamber having an enclosing border, the enclosing border extending around a coating region having at least three planar surfaces and abutting an access portion positioned in an axial orientation relative to the at least three planar surfaces;
a fluid introduction system comprising a vacuum pump and a fluid introduction arrangement arranged and disposed to introduce a fluid to the non-cuboid coating chamber for chemical vapor deposition coating of an article in the non-cuboid coating chamber; and
an arrangement of radiant heating elements positioned outside of the non-cuboid coating chamber and thermally connected with the enclosing border of the non-cuboid coating chamber to heat zones within the non-cuboid coating chamber.

18. The chemical vapor deposition system of claim 17, further comprising a heat-directing enclosure surrounding radiant heating elements and arranged and disposed to direct heat from the radiant heating elements into the first coating chamber.

19. The chemical vapor deposition system of claim 17, wherein the first coating chamber is devoid of heaters, reflectors, water-cooling elements, and heat-spreading elements.

20. The chemical vapor deposition system of claim 17, wherein the fluid introduction arrangement includes one or more valves for the introducing of the fluid.
